# DEMANDE DE BREVET EUROPEEN

(11) **EP 3 789 783 A1**
(43) Date de publication de la demande: **10.03.2021**
(21) Numéro de dépôt: 20194631.6
(22) Date de dépôt: 04.09.2020
(51) Int. Cl.: G01R 33/00, G01R 33/12

(54) **DISPOSITIF DE MESURE COMPORTANT UN GÉNÉRATEUR DE CHAMP MAGNÉTIQUE ET PROCÉDÉ DE MESURE ASSOCIÉ**

(30) Priorité: 06.09.2019 FR 1909845
(71) Demandeur: Magnisense SE, 75008 Paris (FR)
(72) Inventeur: CACIU, Costin, 69003 Lyon (FR)
(74) Mandataire: Lavoix

(57) **Abrégé**

L'invention concerne un dispositif de mesure d'un paramètre d'un échantillon, le dispositif comportant un volume de mesure configuré pour accueillir l'échantillon, et un premier module de contrôle configuré pour alimenter électriquement un module de mesure avec un courant électrique d'alimentation, le module de mesure comportant un générateur de champ magnétique, un capteur et un deuxième module de contrôle, le générateur de champ magnétique étant configuré pour générer un champ magnétique dans le volume de mesure, le capteur étant configuré pour mesurer des valeurs d'une variable du volume de mesure lors de la génération du champ magnétique, le deuxième module de mesure contrôle étant configuré pour calculer une valeur du paramètre en fonction d'au moins une valeur de la variable.

Le premier module de contrôle est configuré pour, suite à la génération du champ magnétique, inhiber l'alimentation du module de mesure pendant une première durée temporelle (dn) prédéterminée.

## Description

La présente invention concerne un dispositif de mesure d'un premier paramètre d'un échantillon. La présente invention concerne également un procédé de mesure mis en œuvre par un tel dispositif.

Des dispositifs prévus pour mesurer des paramètres d'un échantillon, par exemple la concentration en certaines espèces d'un liquide, à l'aide d'un champ magnétique sont utilisés dans de nombreuses applications, notamment relative à la médecine. Par exemple, il est connu de mesurer dans un échantillon de fluide corporel, notamment de sang, des concentrations de différents analytes tels que des enzymes, des anticorps, des ions, des protéines ou encore des micro-organismes.

Pour cela, l'échantillon est inséré dans une chambre prévue à cet effet, dans laquelle il est généré un champ magnétique, par exemple un champ magnétique continu ou alternatif. La présence de ce champ magnétique génère une réponse de l'échantillon, qui prend notamment la forme d'une modification du champ magnétique. Une ou plusieurs valeurs d'une variable de la chambre, notamment d'une variable dépendant du champ magnétique présent dans la chambre, sont acquises par un capteur à cet effet en présence du champ magnétique, un module de calcul déterminant alors une ou plusieurs valeurs du paramètre en fonction des valeurs mesurées.

De tels dispositifs de mesure présentent une très grande sensibilité, permettant notamment de mesurer des valeurs très faibles du paramètre visé, en particulier de détecter des concentrations très faibles de l'analyte ou des analytes dans l'échantillon.

Cependant, la génération du champ magnétique et sa mesure sont sensibles à la température à laquelle le générateur de champ magnétique et le capteur de champ magnétique, et notamment les cartes électroniques qu'ils contiennent se trouve. En particulier, lorsque la température de ces éléments n'est pas constante, la sensibilité des mesures diminue drastiquement.

Cela est problématique du fait que, lors de leur fonctionnement, le générateur, le capteur et le module de calcul dissipent naturellement de la chaleur. Il en résulte que, lorsque l'on allume le dispositif de mesure après un temps de repos important, par exemple lorsque le dispositif de mesure a été éteint pour la nuit, la température du générateur, du capteur et du module de calcul augmentent progressivement sur une plage temporelle pouvant atteindre plusieurs dizaines de minutes voire plus d'une heure, avant de se stabiliser. Ainsi, il est possible d'effectuer des mesures avec une précision acceptable pendant une courte période initiale pendant laquelle le dispositif de mesure est encore froid, puis après stabilisation de la température, mais pas pendant la longue plage temporelle où la température est en augmentation. Il en résulte que le dispositif de mesure est fréquemment indisponible pendant des plages horaires significatives, alors qu'il pourrait être nécessaire d'effectuer des mesures pendant ces plages horaires.

Il existe donc un besoin pour un dispositif de mesure d'un paramètre d'un échantillon via une excitation de l'échantillon par un champ magnétique, qui présente une meilleure disponibilité que les dispositifs de mesure de l'état de la technique, tout en conservant une bonne sensibilité.

A cet effet, il est proposé un dispositif de mesure d'un premier paramètre d'un échantillon, le dispositif comportant un volume de mesure configuré pour accueillir l'échantillon, un premier module de contrôle et un module de mesure, le premier module de contrôle étant configuré pour alimenter électriquement le module de mesure avec un courant électrique d'alimentation,
le module de mesure comportant un générateur de champ magnétique, un capteur et un deuxième module de contrôle, le générateur de champ magnétique étant configuré pour générer un champ magnétique d'excitation dans le volume de mesure, le capteur étant configuré pour mesurer des valeurs d'une variable du volume de mesure lors de la génération du champ magnétique d'excitation, le deuxième module de mesure contrôle étant configuré pour calculer une valeur du premier paramètre en fonction d'au moins une valeur de la variable, la variable étant notamment une intensité du champ magnétique dans le volume de mesure,
le premier module de contrôle étant configuré pour, suite à la génération du champ magnétique d'excitation, inhiber l'alimentation du module de mesure pendant une première durée temporelle prédéterminée.

Selon des modes de réalisation particuliers, le dispositif de mesure comporte l'une ou plusieurs des caractéristiques suivantes, prise(s) isolément ou suivant toutes les combinaisons techniquement possibles :
- la première durée temporelle est comprise entre 4 minutes et 6 minutes.
- le dispositif de mesure comporte, en outre, un détecteur propre à détecter la présence d'un échantillon dans le volume de mesure, le premier module de contrôle étant configuré pour, suite à la détection de la présence d'un échantillon dans le volume de mesure, alimenter électriquement le module de mesure à l'issue d'une deuxième durée temporelle prédéterminée, l'alimentation étant inhibée tant qu'une troisième durée temporelle, mesurée depuis la dernière génération d'un champ magnétique d'excitation par le dispositif de mesure, est inférieure ou égale à la première durée temporelle.
- le premier module de contrôle est configuré pour, lorsqu'aucun échantillon n'est présent dans le volume de mesure, alimenter électriquement le module de mesure pendant une succession de plages temporelles, le générateur générant le champ magnétique d'excitation au cours de chaque plage temporelle, les plages temporelles étant répétées périodiquement avec un période temporelle prédéterminée supérieure ou égale à la première durée, le deuxième module de contrôle étant configuré pour calculer, pour chaque plage temporelle, une valeur initiale d'un deuxième paramètre du volume de mesure à partir d'au moins une valeur de la variable mesurées au cours de la plage temporelle, les valeurs du premier paramètre étant calculées en fonction d'au moins une valeur initiale calculée.
- le dispositif de mesure comporte, en outre, une chambre d'incubation configuré pour accueillir l'échantillon et pour maintenir l'échantillon à une température prédéterminée, le premier module de contrôle étant configuré pour :
   - détecter une insertion de l'échantillon dans la chambre d'incubation à un instant d'insertion,
   - estimer un instant de fin d'incubation, postérieur à l'instant d'insertion et séparé de l'instant d'insertion par une durée d'incubation prédéterminée, et
   - inhiber l'alimentation du module de mesure pendant chaque plage temporelle antérieure à l'instant de fin d'incubation et séparée de l'instant de fin d'incubation par une durée temporelle inférieure ou égale à la première durée.
- le champ magnétique d'excitation comporte au moins deux premières composantes fréquentielles, chaque composante fréquentielle présentant une première fréquence distincte de la première fréquence de l'autre composante fréquentielle, le capteur étant configuré pour mesurer des valeurs d'une deuxième composante fréquentielle de la variable, la deuxième composante fréquentielle présentant une deuxième fréquence, la deuxième fréquence étant égale à la somme de deux produit, chaque produit étant le produit d'une des deux premières fréquences et d'un entier différent de zéro.

Il est également proposé un procédé de mesure d'un premier paramètre d'un échantillon, mis en œuvre par un dispositif de mesure comportant un volume de mesure, un premier module de contrôle et un module de mesure, le module de mesure comportant un générateur de champ magnétique, un capteur et un deuxième module de contrôle,
le procédé comportant des étapes de :
- alimentation du module de mesure avec un courant électrique d'alimentation par le premier module de contrôle,
- génération, par le générateur de champ magnétique, d'un champ magnétique d'excitation dans le volume de mesure, l'échantillon étant accueilli dans le volume de mesure,
- mesure, par le capteur lorsque le champ magnétique d'excitation est généré, de valeurs d'une variable du volume de mesure, les valeurs mesurées étant transmises au deuxième module de contrôle, la variable étant notamment une intensité du champ magnétique dans le volume de mesure, et
- calcul, par le deuxième module de contrôle, d'une valeur du premier paramètre en fonction d'au moins une valeur reçue,
le procédé comportant, en outre, suite à la mise en œuvre de l'étape de génération, une étape d'inhibition, par le premier module de contrôle, de l'alimentation du module de mesure pendant une première durée temporelle prédéterminée.

Selon des modes de mise en œuvre particuliers, le procédé comporte l'une ou plusieurs des caractéristiques suivantes, prise(s) isolément ou suivant toutes les combinaisons techniquement possibles :
- le procédé comporte des étapes de :
   - lorsqu'aucun échantillon n'est présent dans le volume de mesure, alimentation électrique du module de mesure pendant une pluralité de plages temporelles par le premier module de contrôle, les plages temporelles étant répétées périodiquement avec une période temporelle prédéterminée supérieure ou égale à la première durée,
   - génération du champ magnétique d'excitation par le générateur et mesure, par le capteur, d'au moins une valeur de la variable pendant chaque plage temporelle, et
   - détermination, par le deuxième module de contrôle, pour chaque plage temporelle, d'une valeur initiale d'un deuxième paramètre du volume de mesure à partir de la ou les valeurs de la variable mesurées au cours de la plage temporelle,
   chaque valeur du premier paramètre étant calculée par le deuxième module de contrôle en fonction d'au moins une valeur initiale déterminée.
- le procédé comporte successivement dans cet ordre des étapes de :
   - mémorisation de chaque valeur initiale dans une mémoire du dispositif de mesure,
   - extinction du dispositif de mesure,
   - allumage du dispositif de mesure,
   - pour une unique plage temporelle, suite à l'étape d'allumage, génération du champ magnétique d'excitation par le générateur, mesure, par le capteur, d'au moins une valeur de la variable pendant la plage temporelle, et détermination, par le deuxième module de contrôle d'une valeur initiale d'un deuxième paramètre du volume de mesure à partir de la ou les valeurs de la variable mesurées au cours de ladite plage temporelle,
   - comparaison de la valeur initiale déterminée lors de la plage temporelle postérieure à l'étape d'allumage et de la valeur initiale déterminée au cours de la dernière étape de détermination mise en œuvre avant l'étape d'extinction, et
   - si une différence entre les deux valeurs initiales comparées est inférieure ou égale à un seuil prédéterminé, calcul d'au moins une valeur du premier paramètre en fonction d'une des deux valeurs initiales comparées.
- le champ magnétique d'excitation comporte au moins deux premières composantes fréquentielles, chaque composante fréquentielle présentant une première fréquence distincte de la première fréquence de l'autre composante fréquentielle, le capteur étant configuré pour mesurer des valeurs d'une deuxième composante fréquentielle de la variable, la deuxième composante fréquentielle présentant une deuxième fréquence, la deuxième fréquence étant égale à la somme de deux produits, chaque produit étant le produit d'une des deux premières fréquences et d'un entier différent de zéro.
- le premier paramètre est une concentration d'éléments-analytes dans l'échantillon, le procédé comportant, préalablement aux étapes de génération, de mesure et de calcul, une étape de mise en contact de l'échantillon avec un ensemble de particules superparamagnétiques, chaque particule étant propre à s'attacher aux éléments-analytes.

Des caractéristiques et avantages de l'invention apparaîtront à la lecture de la description qui va suivre, donnée uniquement à titre d'exemple non limitatif, et faite en référence aux dessins annexés, sur lesquels :
[Fig 1] la figure 1 est une représentation schématique d'un dispositif de mesure d'un premier paramètre d'un échantillon,
[Fig 2] la figure 2 est un ordinogramme de étapes d'un premier exemple de procédé de mesure du premier paramètre mis en œuvre par le dispositif de mesure de la figure 1,
[Fig 3] la figure 3 est une frise chronologique montrant les différentes étapes du premier exemple de procédé,
[Fig 4] la figure 4 est un ordinogramme de étapes d'un deuxième exemple de procédé de mesure du premier paramètre mis en œuvre par le dispositif de mesure de la figure 1, et
[Fig 5] la figure 5 est une frise chronologique montrant les différentes étapes du deuxième exemple de procédé.

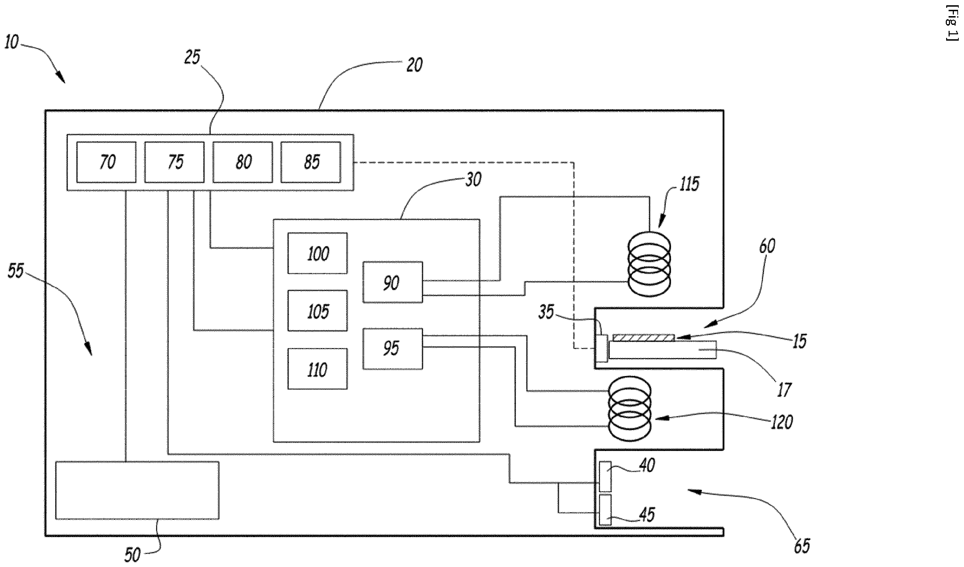

Un dispositif 10 de mesure d'un premier paramètre d'un échantillon 15 est représenté sur la figure 1.

Le dispositif 10 comporte un boîtier 20, un premier module de contrôle 25, un module de mesure 30, un premier détecteur 35, un deuxième détecteur 40, un module de régulation 45 et une interface homme-machine 50.

L'échantillon 15 comporte, par exemple, un fluide, en particulier corporel tel que le sang ou encore la lymphe.

Cependant, de nombreuses variantes dans lesquelles le fluide n'est pas un fluide corporel sont envisageables.

Le premier paramètre est, notamment, une concentration d'éléments-analytes dans l'échantillon 15, en particulier dans le fluide.

Chaque élément-analyte est, par exemple, un ion, un micro-organisme, une protéine, un enzyme, un anticorps, ou encore un antigène. Toutefois d'autres exemples d'éléments-analytes sont également envisageables.

Selon un mode de réalisation, le fluide comporte, en complément des éléments-analytes, un ensemble de particules super-paramagnétiques.

Le superparamagnétisme est la propriété de certains matériaux, notamment de certaines particules ferromagnétiques ou ferrimagnétiques, selon laquelle l'aimantation des particules est nulle en l'absence de champ magnétique externe mais est susceptible d'être très élevée en présence d'un tel champ magnétique.

Chaque particule est réalisée en un matériau ferromagnétique ou ferrimagnétique, tels que Fe₂O₃ ou Fe₃O₄.

Chaque particule présente une dimension maximale, notamment un diamètre, compris entre 150 nanomètres (nm) et 250 nm.

Chaque particule est propre à s'attacher à un ou plusieurs éléments-analytes. Par exemple, chaque particule est fonctionnalisée avec un ensembles de composants fixés à la surface de la molécule et propres à s'attacher à un ou plusieurs éléments-analytes.

Les particules sont de préférence telles que décrites dans le brevet EP 1,262,766, qui est incorporé ici par référence.

Le fluide est, par exemple reçu dans un récipient ou, en particulier, porté de manière connue par une bandelette de test 17.

Le boîtier 20 délimite une chambre principale 55, une chambre de mesure 60 et une chambre d'incubation 65. Le boîtier 20 est configuré pour isoler la chambre principale 55, la chambre de mesure 60 et la chambre d'incubation 65 l'une de l'autre.

Le boîtier 20 est, en outre, configuré pour isoler la chambre principale 55, la chambre de mesure 60 et la chambre d'incubation 65 de l'extérieur du boîtier 20.

La chambre principale 55 accueille par exemple le premier module de contrôle 25 et, au moins partiellement, le module de mesure 30.

La chambre de mesure 60 est configurée pour accueillir l'échantillon 15. Comme il apparaîtra plus bas, la chambre de mesure 60 forme un volume de mesure en ce que le dispositif de mesure 10 est configuré pour mesurer un premier paramètre de l'échantillon 15 lorsque l'échantillon 15 est accueilli dans la chambre de mesure 60.

Il est à noter que selon des variantes envisageables, le volume de mesure n'est pas formé par une chambre ménagée dans le boîtier 20, mais par exemple par une zone externe au boîtier 20, le dispositif de mesure 20 étant prévu pour mesurer le premier paramètre lorsque l'échantillon 15 est disposé dans cette zone.

La chambre d'incubation 65 est configurée pour accueillir l'échantillon 15.

Le premier module de contrôle 25 comporte un premier module de gestion 70, un deuxième module de gestion 75, une première mémoire 80 et un premier processeur 85.

Comme représenté sur la figure 1, le premier module de gestion 70 et le deuxième module de gestion 75 sont réalisés chacun sous forme d'un logiciel, ou d'une brique logicielle, exécutables par le premier processeur 85. La première mémoire 80 est alors apte à stocker le premier logiciel de gestion et un deuxième logiciel de gestion. Le premier processeur 85 est alors apte à exécuter chacun des logiciels.

En variante non représentée, le premier module de gestion 70 et le deuxième module de gestion 75 sont réalisés chacun sous forme d'un composant logique programmable, tel qu'un FPGA (de l'anglais *Field Programmable Gate Array*), ou encore sous forme d'un circuit intégré dédié, tel qu'un ASIC (de l'anglais *Application Specific Integrated Circuit*).

Lorsque le premier module de gestion 70 et le deuxième module de gestion 75 sont réalisés sous forme d'un ou plusieurs logiciels, c'est-à-dire sous forme d'un programme d'ordinateur, ils sont en outre aptes à être enregistrés sur un support, non représenté, lisible par ordinateur. Le support lisible par ordinateur est par exemple, un médium apte à mémoriser les instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple EPROM, EEPROM, FLASH, NVRAM), une carte magnétique ou une carte optique. Sur le support lisible est alors mémorisé un programme d'ordinateur comportant des instructions logicielles.

Le premier module de gestion 70 est configuré pour alimenter électriquement le module de mesure 30 avec un courant électrique d'alimentation.

Le courant électrique d'alimentation est, par exemple, un courant électrique continu. En variante, le courant électrique d'alimentation est un courant électrique alternatif.

Le premier module de gestion 70 est, en outre, configuré pour échanger des informations avec le module de mesure 30.

Le deuxième module de gestion 75 est configuré pour commander la transmission d'informations entre le premier module de contrôle 25 et l'interface homme-machine 50.

Le module de mesure 30 est configuré pour mesurer le premier paramètre de l'échantillon 15 lorsque l'échantillon 15 est accueilli dans la chambre de mesure 60.

Le module de mesure 30 est prévu pour être alimenté électriquement avec le courant électrique d'alimentation. En particulier, le module de mesure 30 est dépourvu d'alimentation électrique et de moyens de stockage d'énergie électrique, de sorte que le module de mesure 30 ne peut fonctionner en l'absence du courant électrique d'alimentation.

Le module de mesure 30 comporte un générateur de champ magnétique 90, un capteur 95, un deuxième module de contrôle 100, une deuxième mémoire 105 et un deuxième processeur 110.

Le générateur de champ magnétique 90 est configuré pour générer un champ magnétique d'excitation dans le volume de mesure.

Par exemple, le générateur de champ magnétique 90 est configuré pour générer le champ magnétique d'excitation systématiquement lorsque le module de mesure 30 est alimenté électriquement. Ainsi, dans la suite de la description, la mention d'un instant temporel ou d'une durée temporelle où l'alimentation électrique de ce module de mesure 30 a lieu et la mention d'un instant temporel ou d'une durée temporelle où le champ magnétique d'excitation est généré sont interchangeables.

Le champ magnétique d'excitation est, notamment, un champ magnétique variable. Il est à noter que l'intensité du champ magnétique d'excitation est susceptible de varier.

Par exemple, le champ magnétique d'excitation présente au moins une première composante fréquentielle, notamment deux premières composantes fréquentielles distinctes l'une de l'autre.

Chaque première composante fréquentielle présente une première fréquence f1, f1'.

Les premières fréquences f1, f1' des deux premières composantes fréquentielles sont distinctes l'une de l'autre.

Par exemple, l'une des premières fréquences f1 est égale à 100 Hertz (Hz), l'autre première fréquence f1' étant égale à 100 kiloHertz (kHz).

Le générateur de champ magnétique 90 comporte, par exemple, un premier enroulement 115 électriquement conducteur. Le premier enroulement 115 est configuré pour générer le champ magnétique d'excitation à l'intérieur du volume de mesure lorsqu'un courant électrique de génération circule dans le premier enroulement 115.

Le premier enroulement 115 est, par exemple, disposé dans la chambre de mesure 60. En variante, le premier enroulement 115 est disposé hors de la chambre de mesure 60.

Le courant électrique de génération est, par exemple, un courant électrique généré par le deuxième module de contrôle 100 et présentant, pour chaque première composante fréquentielle, une deuxième composante fréquentielle présentant une fréquence égale à la première fréquence f1, f1' de la première composante fréquentielle considérée.

Le capteur 95 est configuré pour mesurer des valeurs d'une variable du volume de mesure.

La variable est, notamment, une valeur de champ magnétique à l'intérieur du volume de mesure. En variante, la variable est une valeur de champ magnétique à proximité du volume de mesure.

Le capteur 95 est configuré pour déduire des valeurs de la variable mesurée des valeurs d'une deuxième composante du champ magnétique. La deuxième composante présente une deuxième fréquence f2.

La deuxième fréquence f2 est égale à la somme de deux produits.

Chaque produit est le produit d'une des deux premières fréquences f1, f1' et d'un entier différent de zéro.

Par exemple, le capteur 95 comporte un deuxième enroulement 120.

Le deuxième enroulement 120 est, par exemple, disposé dans la chambre de mesure 60. En variante, comme représenté sur la figure 1, le deuxième enroulement 120 est disposé à l'extérieur de la chambre de mesure 60.

Le capteur 95 est, par exemple, configuré pour mesurer un courant généré dans le deuxième enroulement 120 par le champ magnétique. En particulier, le capteur 95 est configuré pour mesurer une intensité d'une troisième composante du courant présentant la deuxième fréquence f2, cette intensité étant représentative de l'intensité de la deuxième composante du champ magnétique.

Par exemple, le capteur 95 est configuré pour déduire l'intensité de la troisième composante des valeurs d'intensité mesurées, notamment par une analyse fréquentielle des valeurs mesurées. Une telle analyse fréquentielle comporte, par exemple, le calcul de coefficients d'une transformée de Fourier des valeurs d'intensité mesurées.

Le deuxième module de contrôle 100 est configuré pour calculer au moins une valeur du premier paramètre en fonction des valeurs de la variable mesurées par le capteur 95. Par exemple, le deuxième module de contrôle 100 est configuré pour calculer au moins une valeur du premier paramètre en fonction des valeurs d'intensité de la troisième composante. Selon un mode de réalisation, le deuxième module de contrôle 100 est configuré pour calculer la ou les valeur(s) du premier paramètre comme décrit dans le brevet EP 1,262,766.

Le deuxième module de contrôle 100 est, en outre, configuré pour calculer chaque valeur du premier paramètre en fonction des valeurs mesurées par le capteur 95 et d'au moins une valeur, appelée « valeur initiale », d'un deuxième paramètre.

Le deuxième paramètre est, par exemple, une valeur de la variable lorsqu'aucune particule n'est présente dans la chambre de mesure 60. Lors du calcul du premier paramètre, le deuxième paramètre est soustrait aux valeurs de la variable mesurées pour obtenir des valeurs corrigées, le premier paramètre étant calculé à partir des valeurs corrigées.

Le deuxième module de contrôle 100 est, en outre, configuré pour transmettre les valeurs calculées au premier module de contrôle 25.

Le deuxième module de contrôle 100 est sous forme d'un logiciel, ou d'une brique logicielle, exécutable par le deuxième processeur 110 et stocké dans la deuxième mémoire 105.

En variante, le deuxième module de contrôle 100 est réalisé sous forme d'un composant logique programmable, tel qu'un FPGA (de l'anglais *Field Programmable Gate Array*), ou encore sous forme d'un circuit intégré dédié, tel qu'un ASIC (de l'anglais *Application Specific Integrated Circuit*).

Lorsque le deuxième module de contrôle 100 est réalisé sous forme d'un ou plusieurs logiciels, c'est-à-dire sous forme d'un programme d'ordinateur, il est en outre apte à être enregistré sur un support lisible par ordinateur.

Le premier détecteur 35 est configuré pour détecter la présence de l'échantillon 15 dans le volume de mesure, notamment dans la chambre de mesure 60.

Le premier détecteur 35 comporte, par exemple, un bouton actionné par l'échantillon 15, par exemple par la bandelette 17 ou par une cassette dans laquelle la bandelette 17 est insérée, lorsque l'échantillon 15 est accueilli dans la chambre de mesure 60. Toutefois, d'autres types de premiers détecteurs 35 sont également envisageables.

Le premier détecteur 35 est configuré pour transmettre un premier signal de détection au premier module de contrôle 25 lorsque le premier détecteur 35 détecte la présence de l'échantillon 15 dans le volume de mesure.

Le deuxième détecteur 40 est configuré pour détecter la présence de l'échantillon 15 dans le volume de mesure, notamment dans la chambre d'incubation 65.

Le deuxième détecteur 40 comporte, par exemple, un bouton actionné par l'échantillon 15, par exemple par la bandelette 17 ou par une coque dans laquelle la bandelette est insérée, lorsque l'échantillon 15 est accueilli dans la chambre d'incubation 65. Toutefois, d'autres types de deuxièmes détecteurs 40 sont également envisageables.

Le deuxième détecteur 40 est configuré pour transmettre un deuxième signal de détection au premier module de contrôle 25 lorsque le deuxième détecteur 40 détecte la présence de l'échantillon 15 dans la chambre d'incubation 65.

De manière connue en soi, le module de régulation 45 est configuré pour maintenir l'échantillon 15 à une température prédéterminée, par exemple comprise entre 18 degrés Celsius (°C) et 25°C lorsque l'échantillon 15 est accueilli dans la chambre d'incubation 65.

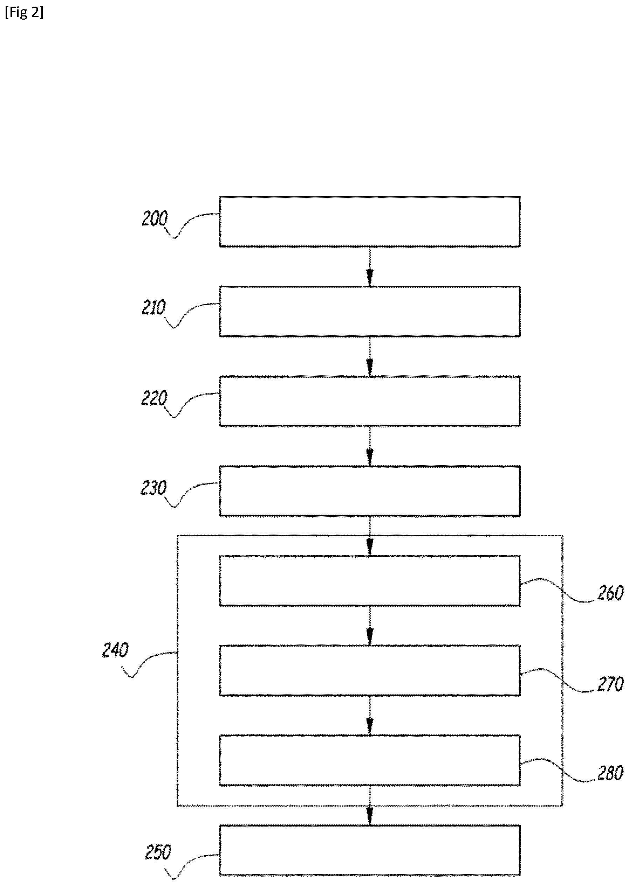

Un premier exemple de procédé de mesure du premier paramètre d'un échantillon 15 va maintenant être décrit en référence à la figure 2, qui est un ordinogramme des étapes du premier exemple de procédé.

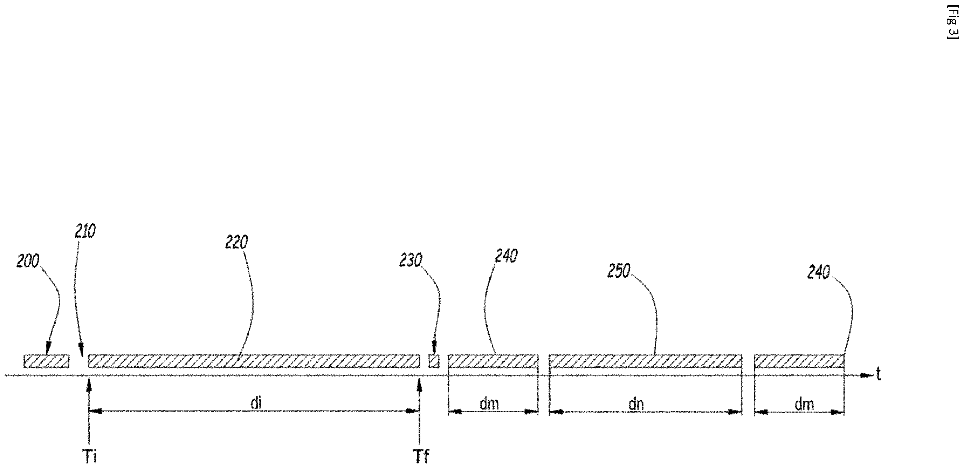

Par ailleurs, un axe des temps t est représenté sur la figure 3. Les différentes étapes, et en particulier leurs durées, sont indiquées sur l'axe des temps t.

Le premier exemple de procédé de mesure est mis en œuvre par le dispositif de mesure 10.

Le premier exemple comporte une étape 200 de mise en contact, une première étape 210 d'insertion, une étape 220 d'incubation, une deuxième étape 230 d'insertion, une étape 240 de mesure et une étape 250 d'inhibition.

L'étape de mise en contact 200 comporte, de manière connue en soi, la mise en contact du fluide destiné à être intégré dans l'échantillon 15 avec un ensemble de particules super-paramagnétiques.

Cette étape de mise en contact est, notamment, comme décrit dans le brevet EP 1 262 766.

Lors de l'étape de mise en contact, les particules sont attachées aux éléments-analytes présents dans l'échantillon 15.

Postérieurement à l'étape de mise en contact, l'échantillon 15 est inséré dans la chambre d'incubation 65 lors de la première étape d'incubation 210.

Le deuxième détecteur 40 détecte la présence de l'échantillon 15 dans la chambre d'incubation 65 et envoie donc le deuxième signal au premier module de contrôle 25.

Le deuxième signal est envoyé au premier module de contrôle 25 à un instant d'insertion Ti.

Suite à la réception du deuxième signal, le premier module de contrôle 25 estime un instant Tf de fin d'incubation.

L'instant de fin d'incubation T est séparé de l'instant d'insertion Ti par une durée temporelle prédéterminée appelée durée d'incubation di.

Lors de l'étape d'incubation 220, l'échantillon 15 est maintenu à une température prédéterminée dans la chambre d'incubation 65 pendant au moins la durée d'incubation di.

La durée d'incubation di est fixée afin de permettre la réalisation et la stabilisation de la réaction du test. Cette durée d'incubation di est susceptible de varier.

Lors de la deuxième étape d'insertion 230, postérieurement à l'étape d'incubation, l'échantillon 230 est retiré de la chambre d'incubation 65 et inséré dans la chambre de mesure 60.

Le premier signal est alors transmis par le premier détecteur 35 au premier module de contrôle 30.

Suite à la réception du premier signal, le premier module de contrôle 25 alimente le module de mesure 30, lors de l'étape de mesure 240, avec le courant électrique d'alimentation.

Par exemple, l'étape de mesure 240 est mise en œuvre pendant une plage temporelle de mesure présentant une durée de mesure dm prédéterminée, le premier module de contrôle 25 alimentant le module de mesure 30 avec le courant électrique d'alimentation pendant la durée de mesure dm et arrêtant l'alimentation lorsque la durée de mesure dm est écoulée.

Lors de l'étape de mise en contact 200, de la première étape d'insertion 210, de l'étape d'incubation 220 et de la deuxième étape d'insertion 230, le premier module de contrôle 25 n'alimente par exemple pas le module de mesure 30 avec le courant électrique d'alimentation.

Lors de l'étape de mesure 240, puisque le module de mesure 30 est alimenté électriquement, le module de mesure 30 met en œuvre une étape 260 de génération, une étape 270 de mesure et une étape 280 de calcul.

Lors de l'étape de génération 260, le générateur 90 génère le champ magnétique d'excitation.

Lors de l'étape de mesure 270, pendant que le champ magnétique d'excitation est généré, les particules induisent, dans le champ magnétique d'excitation, l'apparition de la deuxième composante fréquentielle.

Au moins une valeur de la variable, notamment au moins une valeur d'une intensité de la deuxième composante fréquentielle, est alors mesurée par le capteur 95.

Par exemple, le champ magnétique d'excitation génère l'apparition d'un courant électrique dans le deuxième enroulement 120, la deuxième composante fréquentielle causant l'apparition de la troisième composante fréquentielle dans le courant électrique généré.

Le capteur 95 déduit, par exemple, chaque valeur d'intensité de la deuxième composante fréquentielle via une analyse fréquentielle de valeurs du courant électrique généré, par exemple par une transformation de Fourier.

Chaque valeur de la variable mesurée est transmise au deuxième module de contrôle 100.

Au cours de l'étape de calcul 280, le deuxième module de contrôle 100 calcule au moins une valeur du premier paramètre, par exemple comme décrit dans le brevet EP 1,262,766.

Chaque valeur du premier paramètre est transmise au premier module de contrôle 25, qui la mémorise par exemple dans la première mémoire 80. Chaque valeur du premier paramètre est, par exemple, affichée à destination d'un opérateur par l'interface homme-machine 50.

A l'issue de l'étape de mesure 240, l'étape d'inhibition 250 est mise en œuvre.

En particulier, l'étape d'inhibition est mise en œuvre systématiquement postérieurement à toute période temporelle pendant laquelle le champ magnétique d'excitation est généré, notamment postérieurement à la mise en œuvre de chaque étape de génération 260.

Par exemple, l'étape d'inhibition 250 est mise en œuvre systématiquement lorsque le module de mesure 30 a été alimenté électriquement avec le courant électrique d'alimentation pendant une durée supérieure ou égale à un seuil prédéterminé.

Le seuil prédéterminé est, par exemple, compris entre 1 minute et 2 minutes.

L'étape d'inhibition 250 comporte l'inhibition du module de mesure pendant une durée temporelle prédéterminée, appelée durée d'inhibition dn.

La durée d'inhibition dn est comprise entre 4 minutes et 6 minutes. Cette durée permet de maintenir des températures acceptables pour la mise en œuvre du test biologique.

Il est entendu par « inhibition » que le module de mesure 30 n'est pas alimenté électriquement par le premier module de contrôle 25. En particulier, même si un nouvel échantillon 15 est inséré dans le volume de mesure 60, ou si un opérateur commande la mise en œuvre d'une nouvelle étape de mesure 240 via l'interface homme-machine 50, le module de mesure 30 n'est pas alimenté électriquement.

A l'issue de la durée d'inhibition dn, une nouvelle étape de mesure 240 est, par exemple, mise en œuvre, comme représenté sur la figure 3, si un échantillon 15 est présent dans le volume de mesure 60.

En particulier, si un échantillon 15 est inséré dans le volume de mesure 60 avant la fin de l'étape d'inhibition 250, l'étape de mesure 240 de cet échantillon 15 est mise en œuvre à l'issue de l'étape d'inhibition 250, c'est-à-dire lorsque la durée d'inhibition dn est écoulée depuis la fin de l'étape de mesure 240 précédente.

Grâce à l'utilisation de l'étape d'inhibition, le module de mesure 30 reste froid, puisque le module de mesure 30 a le temps de refroidir pendant l'étape d'inhibition. En effet, le module de mesure 30 est, généralement, responsable de la majorité de la consommation électrique du dispositif de mesure 10, notamment pour générer le champ magnétique d'excitation. La coupure de l'alimentation électrique de ce module de mesure 30 diminue donc grandement la dissipation d'énergie dans le dispositif de mesure 10 et donc la génération de chaleur par celui-ci.

Il s'ensuit que la sensibilité du dispositif de mesure 10 reste sensiblement constante dans le temps, et en particulier ne passe pas par une période pendant laquelle elle diminue drastiquement du fait de la montée en température du module de mesure 30. La sensibilité reste donc très bonne de manière durable.

Pour cela, une durée d'inhibition dn comprise entre 4 minutes et 6 minutes permet en particulier au module de mesure 30 de refroidir efficacement sans limiter excessivement la fréquence à laquelle des mesures peuvent être effectuées.

Il est à noter que des durées d'inhibition dn différentes peuvent être envisagées, en fonction de la conception du module de mesure 30, par exemple plus courtes si celui-ci est bien aéré et peut donc refroidir rapidement ou si le module de mesure 30 consomme peu d'énergie et chauffe donc peu.

Selon une variante du premier exemple, l'étape d'incubation 220 est effectuée dans la chambre de mesure 60. La première étape d'insertion 210 n'est alors pas mise en œuvre, la deuxième étape d'insertion 230 étant mise en œuvre antérieurement à l'étape d'incubation 220. En outre, le module de régulation 45 est configuré pour maintenir la température à l'intérieur de la chambre de mesure 60 égale à la température prédéterminée.

Par exemple, le premier module de contrôle 25 est configuré pour alimenter électriquement, le module de mesure 30, suite à l'émission du premier signal par le premier détecteur 35, à l'issue d'une durée temporelle prédéterminée, qui est par exemple égale à la durée d'incubation di.

Toutefois, tant qu'une durée écoulée depuis le dernier instant où le générateur 90 a généré le champ magnétique d'excitation est inférieure ou égale à la durée d'inhibition, l'alimentation électrique du module de mesure 30 est inhibée par le premier module de contrôle. Cette variante présente l'avantage de pouvoir être mise en œuvre par un dispositif de mesure 10 plus simple, puisqu'il n'est pas nécessaire de prévoir la chambre d'incubation 65.

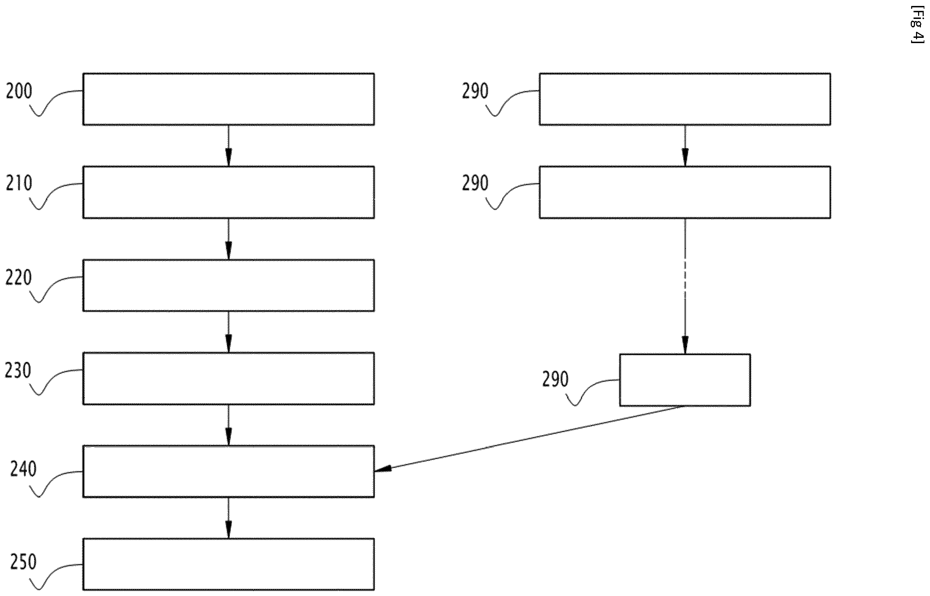

Un deuxième exemple de procédé de mesure mis en œuvre par le dispositif de mesure 10 va maintenant être décrit en référence à la figure 4. Les éléments identiques au premier exemple de procédé ne sont pas décrits à nouveau. Seules les différences sont mises en évidence.

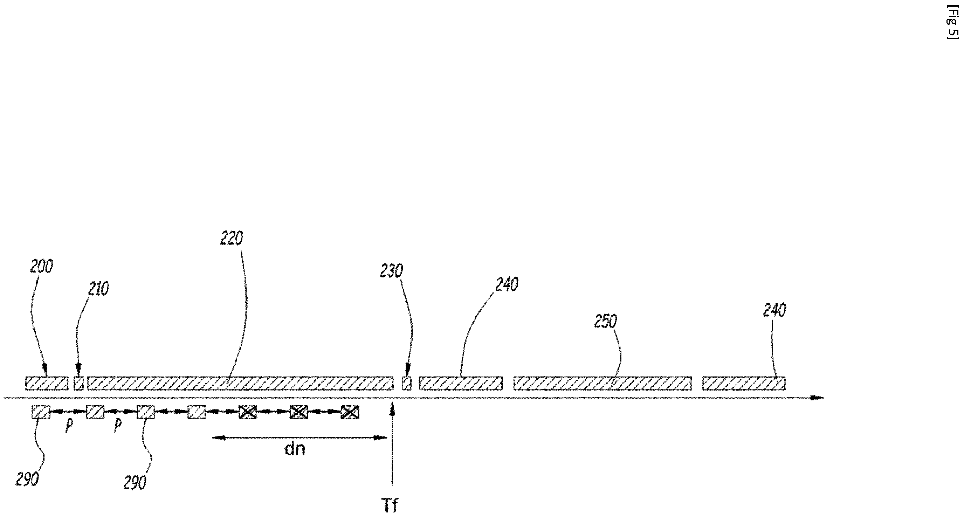

La figure 4 présente un ordinogramme des étapes du deuxième exemple de procédé. Par ailleurs, la figure 5 présente, l'enchaînement et les durées respectives des différentes étapes du deuxième exemple de procédé.

Dans le deuxième exemple de procédé, il est supposé que, lors de l'étape de mise en contact 200, le dispositif de mesure 10 est mis sous tension par un opérateur. En particulier, aucun échantillon 15 n'est présent dans le volume de mesure 60 avant la deuxième étape d'insertion 230.

Le deuxième exemple de procédé comporte une pluralité d'étapes de calibration 290.

Chaque étape de calibration 290 est mise en œuvre pendant une plage temporelle de calibration correspondante. Chaque plage temporelle de calibration présente une durée de calibration dc comprise, par exemple, entre 1 minute et 2 minutes.

Les plages temporelles de calibration sont, par exemple, répétées périodiquement avec une période temporelle P prédéterminée.

La période temporelle P est supérieure ou égale à la durée d'inhibition dn.

La période temporelle P est, par exemple, comprise entre 4 minutes et 6 minutes.

Au cours de chaque plage temporelle de calibration, aucun échantillon 15 n'est accueilli dans le volume de mesure 60.

Par exemple, lorsque le premier détecteur 35 détecte l'absence d'un échantillon 15 dans le volume de mesure 60, le premier module de contrôle 25 commande la mise en œuvre d'une première étape de calibration 290, et commande la mise en œuvre d'étapes de calibration 290 successives tant que le premier détecteur 35 n'émet pas le premier signal indiquant la présence d'un échantillon 15 dans le volume de mesure 60.

En particulier, au moins une étape de calibration 290 est mise en œuvre pendant l'étape d'incubation 220 si aucun échantillon 15 n'est présent dans le volume de mesure 60.

Dans le deuxième exemple de procédé, tel que représenté sur la figure 4, une première étape de calibration 290 est mise en œuvre au cours de l'étape de mise en contact 200, puisque le dispositif de mesure 10 est mis sous tension et qu'aucun échantillon 15 n'est présent dans le volume de mesure 60.

Les étapes de calibration 290 sont, ensuite, répétées périodiquement avec la période temporelle P. Cela est représenté sur la figure 5 par une succession d'étapes de calibration 290 sous l'axe des temps t.

En particulier, les étapes de calibrations 290 sont répétées périodiquement pendant la première étape d'insertion 210 et pendant l'étape d'incubation 220.

Lors de la plage temporelle de calibration associée à chaque étape de calibration 290, le premier module de contrôle 25 alimente électriquement le module de mesure 30.

Cependant, chaque étape de calibration 290 antérieure à l'instant de fin d'incubation Tf et séparée de l'instant de fin d'incubation Tf par une durée temporelle inférieure ou égale à la durée d'inhibition dn est inhibée. En d'autres termes, lors de chaque plage temporelle de calibration antérieure à l'instant de fin d'incubation Tf et séparée de l'instant de fin d'incubation Tf par une durée temporelle inférieure ou égale à la durée d'inhibition dn, l'alimentation du module de mesure 30 est inhibée par le premier module de contrôle 25.

Il est notamment entendu par plage temporelle de calibration « séparée de l'instant de fin d'incubation Tf par une durée temporelle inférieure ou égale à la durée d'inhibition dn » toute plage temporelle de calibration dont au moins un instant temporel, notamment l'instant de fin de la plage temporelle de calibration, est séparé de l'instant de fin d'incubation Tf par une durée temporelle inférieure ou égale à la durée d'inhibition dn.

L'étape de calibration 290 associée à chaque plage temporelle de calibration inhibée n'est pas mise en œuvre. Cela est représenté sur la figure 5 par une pluralité d'étapes de calibration 290 barrées d'une croix.

Lors de chaque étape de calibration 290, puisque le module de mesure 30 est alimenté électriquement, le générateur 90 génère le champ magnétique d'excitation.

En outre, le capteur 95 mesure des valeurs de la variable pendant l'étape de calibration 290.

A partir des valeurs mesurées pendant l'étape de calibration 290, le deuxième module de contrôle 100 calcule une valeur initiale du deuxième paramètre.

Par exemple, la valeur initiale est une valeur moyenne des valeurs mesurées pendant l'étape de calibration 290.

Lors de chaque étape de calibration 290, la valeur initiale du deuxième paramètre calculé est stockée dans la deuxième mémoire 105.

Lors de chaque étape de calcul 280, chaque valeur du premier paramètre est calculée en fonction d'au moins une valeur initiale du deuxième paramètre stockée dans la deuxième mémoire 105, notamment de la valeur initiale stockée lors de la dernière étape de calibration 290 mise en œuvre.

En variante, lors de l'étape de calcul 280, chaque valeur du premier paramètre est calculée à partir d'une valeur moyenne des valeurs initiales calculées pendant une pluralité d'étapes de calibration 290 successives. Par exemple, la valeur moyenne est une valeur moyenne des valeurs initiales calculées pendant les 8 dernières étapes de calibration 290 mises en œuvre.

Grâce à l'utilisation d'étapes de calibration 290 périodiques, toute évolution du dispositif de mesure 10, notamment toute contamination par des éléments pouvant affecter la mesure du premier paramètre, est détectée automatiquement et prise en compte lors de la mesure suivante du premier paramètre. La précision de la mesure est donc améliorée.

Par ailleurs, l'inhibition de chaque étape de calibration 290 séparée de l'instant de fin d'incubation Tf par une durée inférieure ou égale à la durée d'inhibition dn permet d'assurer que la mise en œuvre des étapes de calibration 290 ne retarde pas la mise en œuvre de l'étape de mesure 240. En effet, dans le cas contraire il serait nécessaire d'attendre, à partir de l'insertion 230 de l'échantillon 15 dans le volume de mesure 60 et donc de la cessation des étapes de calibration 290, au moins la durée d'inhibition dn avant de pouvoir effectuer la mesure 240.

Il en résulte une meilleure disponibilité du dispositif de mesure 10, en assurant notamment de pouvoir effectuer les mesures dès que l'échantillon 15 a fini son incubation.

Selon une variante du deuxième exemple de procédé, lorsque le dispositif de mesure est éteint puis rallumé, les étapes suivantes sont mises en œuvre dans cet ordre:
- mémorisation de chaque valeur initiale dans la première ou deuxième mémoire 80, 105, par exemple chaque valeur initiale calculée est mémorisée lors de l'étape de calibration 290 lors de laquelle elle a été calculée ;
- extinction du dispositif de mesure 10, par exemple un soir, l'étape d'extinction comportant la coupure de l'alimentation électrique du premier module de contrôle 25 et du module de mesure 30,
- allumage du dispositif de mesure 10, par exemple le lendemain matin ou plusieurs jours plus tard, bien que la durée entre les étapes d'extinction et d'allumage soit susceptible de varier,
- mise en œuvre d'une unique étape de calibration 290, appelée étape de calibration primaire lors d'une unique plage temporelle de calibration, une valeur initiale, appelée valeur primaire, du deuxième paramètre étant calculée pendant cette étape de calibration 290 primaire, et
- comparaison, par le premier module de contrôle 25 ou par le deuxième module de contrôle 100, de la valeur primaire et de la valeur initiale calculée lors de la dernière étape de calibration 290 mise en œuvre avant l'étape d'extinction, appelée valeur stockée.

Suite à l'étape de comparaison, l'une des deux étapes suivantes est mise en œuvre.

Si une différence entre la valeur primaire et la valeur stockée est inférieure ou égale à un seuil prédéterminé, les étapes 200 à 250 sont mises en œuvre selon le premier exemple de procédé. Le seuil prédéterminé est, par exemple, compris entre 50% et 100%.

Lors de l'étape de mesure 240, chaque valeur du premier paramètre est calculée en fonction de la valeur stockée. En variante, chaque valeur du premier paramètre est calculée en fonction de la valeur primaire.

Si la différence est strictement supérieure au seuil, une pluralité d'étapes de calibration 290 sont mises en œuvre successivement, comme décrit dans le deuxième exemple de procédé. En particulier, lors de l'étape de mesure 240, chaque valeur du premier paramètre est calculée à partir d'une valeur moyenne des valeurs initiales calculées.

Cette variante permet de détecter une variation importante de la valeur du deuxième paramètre pendant une période d'inactivité du dispositif de mesure 10 via l'étape de calibration primaire 290.

Si aucune variation importante n'est détectée, il est considéré que le deuxième paramètre est stable et qu'il n'est donc pas nécessaire d'effectuer plusieurs calibrations 290 pour déterminer précisément le deuxième paramètre. En conséquence, l'appareil pourrait démarrer immédiatement une mesure, avec la dernière valeur stockée. La mise en œuvre du procédé de mesure est donc plus rapide.

## Revendications

1. Dispositif de mesure (10) d'un premier paramètre d'un échantillon (15), le dispositif (10) comportant un volume de mesure (60) configuré pour accueillir l'échantillon (15), un premier module de contrôle (25) et un module de mesure (30), le premier module de contrôle (25) étant configuré pour alimenter électriquement le module de mesure (30) avec un courant électrique d'alimentation,
le module de mesure (30) comportant un générateur (90) de champ magnétique, un capteur (95) et un deuxième module de contrôle (100), le générateur de champ magnétique (90) étant configuré pour générer un champ magnétique d'excitation dans le volume de mesure (60), le capteur (95) étant configuré pour mesurer des valeurs d'une variable du volume de mesure (60) lors de la génération du champ magnétique d'excitation, le deuxième module de contrôle (100) étant configuré pour calculer une valeur du premier paramètre en fonction d'au moins une valeur de la variable, la variable étant notamment une intensité du champ magnétique dans le volume de mesure (60),
le dispositif de mesure (10) étant **caractérisé en ce que** le premier module de contrôle (25) est configuré pour, suite à la génération du champ magnétique d'excitation, inhiber l'alimentation du module de mesure (30) pendant une première durée temporelle (dn) prédéterminée.

2. Dispositif selon la revendication 1, dans lequel la première durée temporelle (dn) est comprise entre 4 minutes et 6 minutes.

3. Dispositif selon la revendication 1 ou 2, comportant, en outre, un détecteur (35) propre à détecter la présence d'un échantillon (15) dans le volume de mesure (60), le premier module de contrôle (25) étant configuré pour, suite à la détection de la présence d'un échantillon (15) dans le volume de mesure (60), alimenter électriquement le module de mesure (30) à l'issue d'une deuxième durée temporelle prédéterminée, l'alimentation étant inhibée tant qu'une troisième durée temporelle, mesurée depuis la dernière génération d'un champ magnétique d'excitation par le dispositif de mesure (10), est inférieure ou égale à la première durée temporelle (dn).

4. Dispositif selon l'une quelconque des revendications 1 à 3, dans lequel le premier module de contrôle (25) est configuré pour, lorsqu'aucun échantillon (15) n'est présent dans le volume de mesure (60), alimenter électriquement le module de mesure (30) pendant une succession de plages temporelles, le générateur (90) générant le champ magnétique d'excitation au cours de chaque plage temporelle, les plages temporelles étant répétées périodiquement avec un période temporelle (P) prédéterminée supérieure ou égale à la première durée (dn), le deuxième module de contrôle (100) étant configuré pour calculer, pour chaque plage temporelle, une valeur initiale d'un deuxième paramètre du volume de mesure (60) à partir d'au moins une valeur de la variable mesurées au cours de la plage temporelle, les valeurs du premier paramètre étant calculées en fonction d'au moins une valeur initiale calculée.

5. Dispositif selon la revendication 4, comportant, en outre, une chambre d'incubation (65) configuré pour accueillir l'échantillon (15) et pour maintenir l'échantillon (15) à une température prédéterminée, le premier module de contrôle (25) étant configuré pour :
- détecter une insertion (210) de l'échantillon (15) dans la chambre d'incubation (65) à un instant d'insertion (Ti),
- estimer un instant (Tf) de fin d'incubation, postérieur à l'instant d'insertion (Ti) et séparé de l'instant d'insertion (Ti) par une durée d'incubation (di) prédéterminée, et
- inhiber l'alimentation du module de mesure (30) pendant chaque plage temporelle antérieure à l'instant de fin d'incubation (Tf) et séparée de l'instant de fin d'incubation (Tf) par une durée temporelle inférieure ou égale à la première durée (dn).

6. Dispositif selon l'une quelconque des revendications précédentes, dans lequel le champ magnétique d'excitation comporte au moins deux premières composantes fréquentielles, chaque composante fréquentielle présentant une première fréquence distincte de la première fréquence de l'autre composante fréquentielle, le capteur (95) étant configuré pour mesurer des valeurs d'une deuxième composante fréquentielle de la variable, la deuxième composante fréquentielle présentant une deuxième fréquence, la deuxième fréquence étant égale à la somme de deux produit, chaque produit étant le produit d'une des deux premières fréquences et d'un entier différent de zéro.

7. Procédé de mesure d'un premier paramètre d'un échantillon, mis en œuvre par un dispositif de mesure (10) comportant un volume de mesure (60), un premier module de contrôle (25) et un module de mesure (30), le module de mesure (30) comportant un générateur (90) de champ magnétique, un capteur (95) et un deuxième module de contrôle (100),
le procédé comportant des étapes de :
- alimentation (240) du module de mesure (30) avec un courant électrique d'alimentation par le premier module de contrôle (25),
- génération (260), par le générateur de champ magnétique (90), d'un champ magnétique d'excitation dans le volume de mesure (60), l'échantillon (15) étant accueilli dans le volume de mesure (60),
- mesure (270), par le capteur (95) lorsque le champ magnétique d'excitation est généré, de valeurs d'une variable du volume de mesure (60), les valeurs mesurées étant transmises au deuxième module de contrôle (100), la variable étant notamment une intensité du champ magnétique dans le volume de mesure (60), et
- calcul (280), par le deuxième module de contrôle (100), d'une valeur du premier paramètre en fonction d'au moins une valeur reçue,
le procédé étant **caractérisé en ce qu'**il comporte, en outre, suite à la mise en œuvre de l'étape de génération (260), une étape d'inhibition (250), par le premier module de contrôle (25), de l'alimentation du module de mesure (30) pendant une première durée temporelle (dn) prédéterminée.

8. Procédé selon la revendication 7, comportant des étapes de :
- lorsqu'aucun échantillon (15) n'est présent dans le volume de mesure (60), alimentation électrique (290) du module de mesure pendant une pluralité de plages temporelles par le premier module de contrôle (25), les plages temporelles étant répétées périodiquement avec une période temporelle (P) prédéterminée supérieure ou égale à la première durée (dn),
- génération du champ magnétique d'excitation par le générateur (90) et mesure, par le capteur (95), d'au moins une valeur de la variable pendant chaque plage temporelle, et
- détermination, par le deuxième module de contrôle (100), pour chaque plage temporelle, d'une valeur initiale d'un deuxième paramètre du volume de mesure (60) à partir de la ou les valeurs de la variable mesurées au cours de la plage temporelle,
chaque valeur du premier paramètre étant calculée par le deuxième module de contrôle (100) en fonction d'au moins une valeur initiale déterminée.

9. Procédé selon la revendication 7 ou 8, comportant successivement dans cet ordre des étapes de :
- mémorisation de chaque valeur initiale dans une mémoire (105) du dispositif de mesure (10),
- extinction du dispositif de mesure (10),
- allumage du dispositif de mesure (10),
- pour une unique plage temporelle, suite à l'étape d'allumage, génération du champ magnétique d'excitation par le générateur (90), mesure, par le capteur (95), d'au moins une valeur de la variable pendant la plage temporelle, et détermination, par le deuxième module de contrôle (100) d'une valeur initiale d'un deuxième paramètre du volume de mesure (60) à partir de la ou les valeurs de la variable mesurées au cours de ladite plage temporelle,
- comparaison de la valeur initiale déterminée lors de la plage temporelle postérieure à l'étape d'allumage et de la valeur initiale déterminée au cours de la dernière étape de détermination mise en œuvre avant l'étape d'extinction, et
- si une différence entre les deux valeurs initiales comparées est inférieure ou égale à un seuil prédéterminé, calcul d'au moins une valeur du premier paramètre en fonction d'une des deux valeurs initiales comparées.

10. Procédé selon l'une quelconque des revendications 7 à 9, dans lequel le champ magnétique d'excitation comporte au moins deux premières composantes fréquentielles, chaque composante fréquentielle présentant une première fréquence distincte de la première fréquence de l'autre composante fréquentielle, le capteur (95) étant configuré pour mesurer des valeurs d'une deuxième composante fréquentielle de la variable, la deuxième composante fréquentielle présentant une deuxième fréquence, la deuxième fréquence étant égale à la somme de deux produits, chaque produit étant le produit d'une des deux premières fréquences et d'un entier différent de zéro.

11. Procédé selon la revendication 10, dans lequel le premier paramètre est une concentration d'éléments-analytes dans l'échantillon, le procédé comportant, préalablement aux étapes de génération, de mesure et de calcul, une étape de mise en contact de l'échantillon avec un ensemble de particules superparamagnétiques, chaque particule étant propre à s'attacher aux éléments-analytes.
